# EUROPEAN PATENT SPECIFICATION

(11) **EP 4 441 769 B1**
(45) Date of publication and mention of the grant of the patent: **22.10.2025**
(21) Application number: 22823533.9
(22) Date of filing: 01.12.2022
(51) Int. Cl.: H01J 37/20

(54) **METHOD AND DEVICE FOR REGIOSELECTIVE FUNCTIONALIZING A SURFACE OF AN ELECTRON MICROSCOPY GRID**
VERFAHREN UND VORRICHTUNG ZUR REGIOSELEKTIVEN FUNKTIONALISIERUNG EINER OBERFLÄCHE EINES ELEKTRONENMIKROSKOPIEGITTERS
PROCÉDÉ ET DISPOSITIF POUR LA FONCTIONNALISATION RÉGIOSÉLECTIVE D'UNE SURFACE D'UNE GRILLE DE MICROSCOPIE ÉLECTRONIQUE

(30) Priority: 01.12.2021 EP 21211665
(43) Date of publication of application: 09.10.2024
(73) Proprietor: Universiteit Gent, 9000 Gent (BE); IMEC vzw, 3001 Leuven (BE)
(72) Inventor: VAN PUTTE, Wouter, 8600 Diksmuide (BE); REICHERT, Thomas, 8400 Oostende (BE)
(74) Representative: De Clercq & Partners
(86) International application number: PCT/EP2022/083994
(87) International publication number: WO 2023/099642

(56) References cited:
- WO-A1-2020/173952
- ENGEL LEEYA ET AL: "Extracellular matrix micropatterning technology for whole cell cryogenic electron microscopy studies", JOURNAL OF MICROMECHANICS AND MICROENGINEERING, vol. 29, no. 11, 26 September 2019 (2019-09-26), GB, pages 115018, XP055917190, ISSN: 0960-1317, DOI: 10.1088/1361-6439/ab419a
- KATERINA NAYDENOVA ET AL: "Multifunctional graphene supports for electron cryomicroscopy", PROCEEDINGS OF THE NATIONAL ACADEMY OF SCIENCES, 24 May 2019 (2019-05-24), XP055708628, ISSN: 0027-8424, DOI: 10.1073/pnas.1904766116

## Description

### FIELD OF THE INVENTION

The present invention is in the field of electron microscopy (EM), more particularly cryo-electron microscopy (cryo-EM). The invention provides a method and an apparatus for regioselective functionalizing a surface of an electron microscopy grid, which may be used for generating a plurality of sampling zones for determination and structural analysis of different analytes bound to a single grid.

### BACKGROUND OF THE INVENTION

Recent development in the field of electron microscopy and cryo-electron microscopy, allow for structural analysis or structural determination of analytes, such as biomolecules. The increasing demand for cryo-electron microscopy reveals several drawbacks with regards to throughput, sample preparation protocols, sample waste, lack of reproducibility and/or lack of scalability.

EM imaging of EM grids is a time-consuming and expensive process. Especially loading the EM grids in the electron microscope is time consuming, time in which the electron microscope cannot acquire data. Limited numbers of EM grid can be brought into the microscope per loading activity, and limited number of loading activities can be done in a single day. Currently, depending on the ability of the microscope, realistically a maximum of 8 to 24 grids can be screened per day. Therefore, there is a demand to increase the throughput of samples in EM imaging. There is a demand for methods wherein more than one sample or functionalization can be provided on a single EM grid. There is a demand for multiplexing samples on a single EM grid. Preferably, such methods must be easy to perform without the need for highly specialized electronic equipment. Preferably, such methods may avoid cross-contamination between the different sample depositions or functionalizations of a single EM grid. Preferably, the method allows for pure depositions or functionalizations to be made. Preferably, the method allows for washing off unwanted components from the deposition or functionalization. Preferably, the methods strive to optimise the use of the available surface of the EM grid. Preferably, the methods strive to cover a high percentage of the surface of the EM grids with deposits or functionalizations. Preferably, the methods allow for clearly defined functionalizations on the EM grid. In other words, preferably the methods do not allow for one functionalization to fade into another functionalization. Preferably, the methods strive to be more cost efficient in sample preparation. Preferably, the methods strive to be more time efficient in sample preparation. There is also a demand to provide suitable EM grids to be used in such a method. Preferably the EM grids may be used in a standard electron microscope. Preferably, the EM grids do not require any modification on an electron microscope.

Some methods in the art have explored solutions for sample preparation relying on pin-printing methods for sample deposition, which employs a capillary bridge moved across the surface of an EM grid to deposit a volume of sample. However, sample deposits made by such methods, risk to run in to each other while still wet, causing cross-contamination of the different deposits. Hence, sample preparation according to such methods does not provide sufficient reliability. Such methods also require the deposited sample to dry before the grid can be further manipulated. Hence, these methods are also time consuming. Different sample deposits need to be spaced apart on the grid, again to reduce the risk of cross contamination. Hence, a large part of the surface of the grid is not actually used to be covered by sample. Furthermore, the equipment, such as the capillary bridge used to perform sample deposition is a complex and highly expensive piece of equipment, and as such not standardly present in labs. The solution of the sample used in such capillary bridge equipment needs to fulfil certain requirements such as consistency, conductivity, or purity, which as result restricts the typologies of samples that can be deposited. Additionally, these methods further restrict the field of applicability as they do not allow for washing steps to be performed (pre-deposition and/or post- deposition) fostering the risk of cross contamination among different sample deposits. Hence, such methods result to be unsuitable when EM grids operates as an affinity grid.

Some methods in the art use plasma treatment to functionalise the surface of EM grids. However, plasma treatment severely limits the type of functionalizations of the surface, as only a limited number of functional groups can be achieved by plasma treatment. For example, peptide, DNA or oligonucleotide functionalizations cannot be achieved trough plasma treatment. Hence, there is a demand for functionalization methods of EM grids with a high flexibility in type of functionalization.

A method for functionalising EM grids is known from ENGEL Leeya et al.: "Extracellular matrix micropatterning technology for whole cell cryogenic electron microscopy studies", JOURNAL OF MICROMECHANICS AND MICROENGINEERING, vol. 29, no. 11, 26 September 2019, page 115018, XP055917190, ISSN: 0960-1317, DOI: 10.1088/1361-6439/ab419a.

### SUMMARY OF THE INVENTION

It is an object of the present invention to fulfil at least some of the above indicated demands.

The invention provides a method for regioselective functionalizing a surface of an electron microscopy grid (EM grid) (10), preferably a surface of a cryo-electron microscopy (cryo-EM) grid, preferably a surface of an affinity EM grid or an affinity cryo-EM grid, comprising the steps of:
a) providing a surface (20) of an electron microscopy grid (101) to be functionalized, preferably regioselective functionalized;
b) providing a plurality of wall systems (30A, 30B) on at least one part of the surface of an electron microscopy grid, thereby forming a plurality of temporary reaction chambers (40A, 40B) wherein the at least one part of the surface (21A, 21B) of an electron microscopy grid (10) forms a floor or a ceiling of the temporary reaction chambers;
c) providing a modification solution (50) or a different modification solution (50A, 50B) in each temporary reaction chambers (40A, 40B);
d) modifying the parts of the surface (21A, 21B) of an electron microscopy grid (10) in the temporary reaction chambers (40A, 40B) with the modification solution(s) (50, 50A, 50B) or components comprised in the modification solution(s) (50, 50A, 50B);
e) removing the modification solution(s) (50, 50A, 50B) from the temporary reaction chambers (40A, 40B);
f) removing the plurality of wall systems (30A, 30B) from the surface (20) of a microscopy grid (10), thereby providing a regioselective functionalized surface (22A, 22B) of an electron microscopy grid (10).

In some embodiments, the method comprises the following steps, which are carried out after step b) and before step c):
x. providing an activation solution or a different activation solution in the temporary reaction chambers (40A, 40B), wherein the activation solution(s) comprises reactive affinity groups;
y. reacting the part of the surface of a microscopy grid (10) in the temporary reaction chambers (40A, 40B) with the activation solution(s) providing activated parts of the surface, preferably thereby binding the affinity groups to the part of the surface (21A, 21B) of the electron microscopy grid (10) in a plurality of reaction chambers (40A, 40B);
z. removing the activation solution(s) from the temporary reaction chambers (40A, 40B); and; wherein the modification solution(s) (50, 50A, 50B) comprises an analyte, which analyte specifically binds to or reacts with the activated part of the surface, preferably wherein the analyte comprises a binding motif or affinity tag, which specifically binds to, or reacts with the affinity groups.

In some embodiments, the method further comprises the step of washing the temporary reaction chambers (40A, 40B), preferably after step e) and/or z).

Disclosed is further, outside the scope of the claims, an electron microscopy grid comprising a layered structure, wherein the layered structure comprises the following layers, preferably in the following order:
- a substrate, preferably a metal substrate, preferably a metal framework; and,
- optionally a support film or a perforated support film on the substrate,
- a continuous film, comprising a contact surface, which faces the substrate or the support film, and wherein said continuous film comprises an exposed surface opposite to the contact surface;
wherein the substrate and/or the support film comprising a plurality of perforated areas, separated and surrounded by solid areas.

The invention provides further an apparatus for regioselective functionalizing a surface of an electron microscopy grid, comprising:
- a plurality of partially formed reaction chambers, each partially formed reaction chamber comprising at least a wall system;
- for each partially formed reaction chamber, a fluid inlet and/or fluid outlet in fluidly connection to said partially formed reaction chamber;
- an electron microscopy grid holder, to hold the electron microscopy grid and configured to expose the surface to be modified to the partially formed reaction chambers;
- optionally, a press system or clamp system to press the electron microscopy grid and/or the object holder with the electron microscopy grid with the surface against the wall systems.

The invention provides further a method for structurally characterizing different analytes on a single electron microscopy grid, comprising:
- regioselective functionalizing the surface of an electron microscopy grid with different analytes, according to the method according to claims 1 to 9, thereby obtaining different functionalized regions on the electron microscopy grid;
- freezing the electron microscopy grid obtained in a);
- loading the electron microscopy grid obtained in b) into an electron microscope;
- acquiring electron microscopy images for every differently modified region of the electron microscopy grid; and,
- reconstructing the three-dimensional volume of the analytes based on the acquired electron microscopy images.

The present invention will now be further described. In the following passages, different aspects of the invention are defined in more detail. Each aspect so defined may be combined with any other aspect or aspects unless clearly indicated to the contrary. In particular, any feature indicated as being preferred or advantageous may be combined with any other feature or features indicated as being preferred or advantageous.

### BRIEF DESCRIPTION OF THE FIGURES

**Figure 1** depicts a method for regioselective functionalizing a surface (20) of an electron microscopy grid (10) according to an embodiment of the invention.
**Figure 2** depicts a method for regioselective functionalizing a surface (220) of an electron microscopy grid (210) according to an embodiment of the invention, wherein the electron microscopy grid (210) functions as an affinity grid.
**Figure 3** shows a top view of an electron microscopy grid.
**Figure 4** shows a top view of an electron microscopy grid.
**Figure 5a and Figure 5b** show an apparatus for regioselective functionalizing a surface of an electron microscopy grid according to an embodiment of the invention.

### DETAILED DESCRIPTION OF THE INVENTION

Before the present method and products of the invention are described, it is to be understood that this invention is not limited to particular methods, components, products or combinations described, as such methods, components, products and combinations may, of course, vary. It is also to be understood that the terminology used herein is not intended to be limiting, since the scope of the present invention will be limited only by the appended claims.

As used herein, the singular forms "a", "an", and "the" include both singular and plural referents unless the context clearly dictates otherwise. The terms "comprising", "comprises" and "comprised of" as used herein are synonymous with "including", "includes" or "containing", "contains", and are inclusive or openended and do not exclude additional, non-recited members, elements or method steps. It will be appreciated that the terms "comprising", "comprises" and "comprised of" as used herein comprise the terms "consisting of", "consists" and "consists of".

The recitation of numerical ranges by endpoints includes all numbers and fractions subsumed within the respective ranges, as well as the recited endpoints. The term "about" or "approximately" as used herein when referring to a measurable value such as a parameter, an amount, a temporal duration, and the like, is meant to encompass variations of +/-10% or less, preferably +/-5% or less, more preferably +/-1% or less, and still more preferably +/-0.1% or less of and from the specified value, insofar such variations are appropriate to perform in the disclosed invention. It is to be understood that the value to which the modifier "about" or "approximately" refers is itself also specifically, and preferably, disclosed.

Whereas the terms "one or more" or "at least one", such as one or more or at least one member(s) of a group of members, is clear per se, by means of further exemplification, the term encompasses inter alia a reference to any one of said members, or to any two or more of said members, such as, e.g., any ≥3, ≥4, ≥5, ≥6 or ≥7 etc. of said members, and up to all said members.

Unless otherwise defined, all terms used in disclosing the invention, including technical and scientific terms, have the meaning as commonly understood by one of ordinary skill in the art to which this invention belongs. By means of further guidance, term definitions are included to better appreciate the teaching of the present invention.

In the following passages, different aspects of the invention are defined in more detail. Each aspect so defined may be combined with any other aspect or aspects unless clearly indicated to the contrary. In particular, any feature indicated as being preferred or advantageous may be combined with any other feature or features indicated as being preferred or advantageous.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to a person skilled in the art from this disclosure, in one or more embodiments. Furthermore, while some embodiments described herein include some but not other features included in other embodiments, combinations of features of different embodiments are meant to be within the scope of the invention, and form different embodiments, as would be understood by those in the art. For example, in the appended claims, any of the claimed embodiments can be used in any combination.

In the context of the present invention, an electron microscopy grid may alternatively be referred to as an electron microscopy sample support. The term "electron microscopy grid" as used herein may be understood as a sample support used in electron microscopy, a support or grid whereon the analyte is presented for image acquisition in electron microscopy.

The invention provides a method for regioselective functionalizing a surface of an electron microscopy grid (EM grid) (10), preferably a surface of a cryo-electron microscopy (cryo-EM) grid, preferably a surface of an affinity EM grid or an affinity cryo-EM grid, comprising the steps of:
a) providing a surface (20) of an electron microscopy grid (101) to be functionalized, preferably regioselective functionalized;
b) providing a plurality of wall systems (30A, 30B) on at least one part of the surface of an electron microscopy grid, thereby forming a plurality of temporary reaction chambers (40A, 40B), preferably wherein the at least one part of the surface (21A, 21B) of an electron microscopy grid (10) forms a floor or a ceiling of the temporary reaction chambers;
c) providing a modification solution (50) or a different modification solution (50A, 50B) in each temporary reaction chambers (40A, 40B);
d) modifying the parts of the surface (21A, 21B) of an electron microscopy grid (10) in the temporary reaction chambers (40A, 40B) with the modification solution(s) (50, 50A, 50B) or components comprised in the modification solution(s) (50, 50A, 50B);
e) removing the modification solution(s) (50, 50A, 50B) from the temporary reaction chambers (40A, 40B);
f) removing the plurality of wall systems (30A, 30B) from the surface (20) of a microscopy grid (10), thereby providing a regioselective functionalized surface (22A, 22B) of an electron microscopy grid (10).

The method allows for regioselective functionalization of a surface of an electron microscopy grid. The formation of plurality of temporary reaction chambers on the surface, wherein different modification solutions can be provided, avoids the risk that different modification solutions run into each other, such that unwanted mixture of different modification solutions and co-functionalization is avoided. The method provides a robust and reliable way of sample preparation to provide multiple functionalizations e.g., multiple analytes, on a single electron microscopy grid. The method can be performed without the need for expensive equipment, the modification solution can be applied to the temporary reaction chamber with a pipet, or any liquid handling system generally present in a laboratory. The method has also the advantage that the surface of the obtained regioselective functionalized electron microscopy grid is free of any structures other than the functionalization. Other structures on the surface of an EM grid may interfere with the loading of the fully prepared grids into the electron microscope, or interfere with the data acquisitioning or data processing.

The term "functionalizing a surface" as used herein may refer to amending the physical or chemical properties of a surface. "Functionalizing a surface" can be done chemically and/or physically. Functional groups on the surface may be chemically converted. Molecules, biomolecules, proteins, affinity tags, analytes or particles may be bound to the surface, either chemically or physically, to functionalize the surface. "Functionalizing a surface" may involve depositing a sample on the surface, preferably after which the sample is bound to the surface either or after which the sample adheres to the surface.

The term "regioselective functionalization" as used herein may refer to different functionalization in different regions of the EM grid. Preferably, the different functionalizations are spaced apart from each other. Preferably, the different functionalizations do not overlap.

The term "modifying" as used herein, may involve reacting, coating, depositing, adhering a compound to the surface. "Modifying" may involve the formation of a chemical bonds, physical bonds, or electrostatic bonds. Chemical bonds may entail ionic bonds, covalent bonds, metallic bonds, inter-molecular bonds, etc. In some embodiments, the term "modifying" means "reacting". In some embodiments, the surface to be functionalized comprises functional groups, such as amine or carboxylic groups, which react with functional groups present on the compounds in the modification solution or activation solution, preferably such that amide bonds or ester bond are formed, thereby covalently linking compounds of the modification solution or activation solution to the surface.

In some embodiments, the method for regioselective functionalizing a surface of an electron microscopy grid is a method for regioselective depositing samples on an electron microscopy grid.

The term "modification solution" as used herein, may refer to a solution agents, analytes or compounds that react with the surface or will bind or adhere to the surface. The modification may comprise a single agent, analyte or compound, or it may comprise a mixture of multiple agents, analytes or compounds. The modification solution may be a mixture of analytes, of which only a single analyte will bind a specific part of the surface, for example this can be done by analytes which comprise different affinity groups, and wherein the different parts of the surface are modified by a different affinity tag, or *vice versa.*

The term "wall system" as used herein, may refers to a concatenation or reactor walls elements, which when placed on a surface or pressed against a surface, form together with that surface a functioning temporary reaction chamber or functioning temporary reaction well. In embodiments, where the part of the surface to be functionalized forms the floor of the temporary reaction chamber, the top of the reaction chamber may be open or may comprise a ceiling element. In some embodiments, where the part of the surface to be functionalized forms the ceiling of the temporary reaction chamber, the wall system comprises a flooring element. Preferably, the seams between different reactor walls elements, floor elements, and ceiling elements are fluid impermeable. Preferably the seams are sealed. In some embodiments, the wall system comprises wall elements seamlessly connected to each other. In some embodiments, the wall system is tooled, carved or etched from a single piece of material; a material like metal or plastic. In some embodiments, the term "wall system" may refer to a system of vertical delimitations, perpendicularly positioned with respect to an electron microscopy grid. In some embodiment, the term "wall system" may refer to a structure which is superimposed onto an electron microscopy grid in a removable fashion. In some embodiments, wall systems are configured to be allocated onto a part of the surface or onto the totality of the surface of an electron microscopy grid. Preferably, said wall systems are perpendicularly positioned with respect to the electron microscopy grid. In some embodiments, different wall systems may be connected to each other or share a wall element.

In some embodiments, the wall systems may be fabricated in metal, preferably a metal-alloy, and preferably may be fabricated through milling, preferably CNC high-precision milling.

In some embodiments, the wall systems may be fabricated in metal, preferably a metal-alloy. Preferably, the wall systems may be fabricated through milling, preferably CNC high-precision milling, EDM milling or any other fabrication technique that generates a very smooth surface finish. In addition, the surface quality of the fabricated parts might be further improved via dedicated postprocessing such as electropolishing or lapping.

The wording "temporary reaction chambers" as used herein may refer to reaction chambers that are not permanently present on the surface of the electron microscopy grid. Preferably, the temporary reaction chambers are functioning reaction chambers, starting from providing the wall systems on at least one part of the surface in step b) to the removal of the wall systems from the surface in step f). Preferably, the "temporary reaction chambers" are not present on the electron microscopy grids when these are placed inside the electron microscope for data acquisition. Preferably, the "temporary reaction chambers" are not present on the electron microscopy grids during freezing of the EM grids.

In some embodiments, the plurality of wall chambers comprises at least 2 wall systems, forming a least 2 temporary reaction chambers, preferably at least 4 wall systems, forming at least 4 temporary reaction chambers, preferably at least 6 wall systems, forming at least 6 temporary reaction chambers, preferably at least 8 wall systems, forming at least 8 temporary reaction chambers, preferably at least 10 wall systems, forming at least 10 temporary reaction chambers, preferably at least 12 wall systems, forming at least 12 temporary reaction chambers.

In some embodiments, the plurality of wall chambers comprises at most 24 wall systems, forming at most 24 temporary reaction chambers, preferably at most 22 wall systems, forming at most 22 temporary reaction chambers, preferably at most 20 wall systems, forming at most 20 temporary reaction chambers, preferably at most 18 wall systems, forming at most 18 temporary reaction chambers, preferably at most 16 wall systems, forming at most 16 temporary reaction chambers, preferably at most 14 wall systems, forming at most 14 temporary reaction chambers.

In some embodiments, the plurality of wall chambers comprises at least 2 to at most 24 wall systems, forming at least 2 to at most 24 temporary reaction chambers, preferably at least 4 to at most 22 wall systems, forming at least 4 to at most 22 temporary reaction chambers, preferably at least 6 to at most 20 wall systems, forming at least 6 to at most 20 temporary reaction chambers, preferably at least 8 to at most 18 wall systems, forming at least 8 to at most 18 temporary reaction chambers, preferably at least 10 to at most 16 wall systems, forming a least 10 at most 16 temporary reaction chambers, preferably at least 12 to at most 14 wall systems, forming a least 12 to at most 14 temporary reaction chambers.

In some embodiments, the method comprising the following steps, which are preferably carried out after step b) and before step c):
x. providing an activation solution or a different activation solution in the temporary reaction chambers (40A, 40B), preferably wherein the activation solution(s) comprises reactive affinity groups;
y. reacting the part of the surface of a microscopy grid (10) in the temporary reaction chambers (40A, 40B) with the activation solution(s) providing activated parts of the surface, preferably thereby binding the affinity groups to the part of the surface (21A, 21B) of the electron microscopy grid (10) in a plurality of reaction chambers (40A, 40B);
z. removing the activation solution(s) from the temporary reaction chambers (40A, 40B);
wherein the modification solution(s) (50, 50A, 50B) comprises an analyte, which analyte specifically binds to or reacts with the activated part of the surface, preferably wherein the analyte comprises a binding motif or affinity tag, which specifically binds to, or reacts with the affinity groups.

Such a method may be used to turn the electron microscopy grid into an affinity grid, which may be regioselective modified. The method binds the reactive affinity groups of the activation solution to the part of the surface of the EM grid that is enclosed by the temporary reaction chamber, before the modification solution is applied in the temporary reaction chamber. The affinity groups may selectively bind to the analyte in the modification solution, linking the analyte to the surface of the EM grid within the temporary reaction chamber.

The term "affinity group" as used herein, should be interpreted as a group that specifically bind to a certain binding motif or affinity tag on the analyte. Hence, using an affinity group a certain analyte can be immobilized on the grid in the presence of other molecules. For example, a tagged protein can selectively be immobilized out of a cell lysate. This may reduce the need to purify the analyte before attempting to bind the analyte to the surface of the EM grid. When such affinity groups are bound to the surface of the EM grid, the grid may be classified as an "affinity grid". In some embodiments, the analyte can also be a binding partner of a second analyte, such as a Fab fragment, whereby the Fab fragment is immobilized first to the grid, followed by the second specific protein target.

In some embodiments, the electron microscopy grid is an affinity electron microscopy grid.

In some embodiments, the affinity group may be selected from the list of a deoxyribonucleic acid (DNA), a ribonucleic acid (RNA), a sugar, a peptide, a protein (e.g. an antibody or a nanobody), a lipid, a nickel nitrilotriacetic acid (Ni-NTA), cobalt nitrilotriacetic acid (Co-NTA), HaloTag^{®} Ligand (e.g. obtained from Promega), haloalkane tag, chloro-alkane tag, SnapTag^{®} Ligand (e.g. obtained from NEB), SpyTag, SpyCatcher, a peptide sequence recognized and ligated by Sortase A, or any other natural or synthetic chemical probe that can be used to selectively bind a specific analyte.

In some embodiments, the affinity tag on the analyte may be selected from the list of HisTag, a HaloTag^{®}, a SnapTag^{®}, SpyTag, SpyCatcher, etc. Other useable affinity tags and corresponding affinity groups are for example, without being limited thereto, as described by Kimple et al. (KIMPLE, Michelle E.; BRILL, Allison L.; PASKER, Renee L. Overview of affinity tags for protein purification. Current protocols in protein science, 2013, 73.1: 9.9. 1-9.9. 23.), which is incorporated herein by reference; see therein for example Table 9.9.1.

The term "reactive affinity group" refer to affinity groups linked to a reactive moiety, preferably affinity groups linked to an anchoring group.

In some embodiment, the reactive affinity groups may be a linker molecule, comprising an affinity group on one end, and a reactive anchoring group on the other hand.

The term "anchoring groups" refers to a group suitable for anchoring the linker or an affinity group to the surface. In some embodiments, the anchoring group (AG) is an amine group, a maleimide group, a thiol group, a diazonium group or a carbonyl group.

In some embodiments, modifying the surface with an activation solution comprising linker molecules or reactive affinity groups may involve electrochemical or chemical activation of the anchoring group, e.g. the diazonium group, for example by an electrochemical or chemical reduction.

In some embodiments, the surface to be functionalized may be surface treated prior to modification with the activation solution or the modification solution. For example, a carboxyl group may for example be formed on graphene through an oxidation procedure based on UV-ozone treatment or KMnO₄ treatment, while other chemical groups can be attached through plasma-based chemical functionalization. Preferably, the surface treatment introduces reactive groups on the surface which can react with the anchoring groups or the reactive affinity groups.

In some embodiment, the linker molecule may comprise an alkyl chain, a polyester, a polyether, a polyalcohol, a polyglycol, a poly(N-isopropylacrylamide) (PNIPAM), a polyacrylamide (PAM), a poly(acrylic acid), a polymethacrylate, an acrylic polymer, polyethylene glycol (PEG), a peptide, DNA, RNA, peptide nucleic acid (PNA) or another DNA mimic.

In some embodiments, the surface of the electron microscopy grid comprises anchoring groups.

In some embodiments, the surface of the electron microscopy grid comprises affinity groups.

In some embodiments, the analyte may be a biomolecule, a lipid vesicle, or a nanoparticle, preferably a protein, a nucleic acid, a carbohydrate, a lipid vesicle, a nanoparticle or a combination thereof. The analyte may be a complex, such as a complex of biomolecules, or a complex of a biomolecule and a ligand, a drug candidate or small molecule.

In some embodiments, the method comprising the steps of:
a) providing a surface (20) of an electron microscopy grid (101) to be regioselective functionalized;
b) providing a plurality of wall systems (30A, 30B) on at least one part of the surface of an electron microscopy grid, thereby forming a plurality of temporary reaction chambers (40A, 40B) wherein the at least one part of the surface (21A, 21B) of an electron microscopy grid (10) forms a floor or a ceiling of the temporary reaction chambers (40A, 40B);
   x. providing an activation solution or a different activation solution in the temporary reaction chambers (40A, 40B), wherein the activation solution(s) comprises reactive affinity groups;
   y. reacting the part of the surface of a microscopy grid (10) in the temporary reaction chambers (40A, 40B) with the activation solution(s) providing activated parts of the surface, preferably thereby binding the affinity groups to the part of the surface (21A, 21B) of the electron microscopy grid (10) in a plurality of reaction chambers (40A, 40B);
   z. removing the activation solution(s) from the temporary reaction chambers (40A, 40B);
c) providing a modification solution (50) or a different modification solution (50A, 50B) in each temporary reaction chambers (40A, 40B);
d) modifying the parts of the surface (21A, 21B) of an electron microscopy grid (10) in the temporary reaction chambers (40A, 40B) with the modification solution(s) (50, 50A, 50B) or components comprised in the modification solution(s) (50, 50A, 50B);
e) removing the modification solution(s) (50, 50A, 50B) from the temporary reaction chambers (40A, 40B);
f) removing the plurality of wall systems (30A, 30B) from the surface (20) of a microscopy grid (10), thereby providing a regioselective functionalized surface (22A, 22B) of an electron microscopy grid (10);
wherein the modification solution(s) (50, 50A, 50B) comprises an analyte, which analyte specifically binds to or reacts with the activated part of the surface, preferably wherein the analyte comprises a binding motif or affinity tag, which specifically binds to, or reacts with the affinity groups.

In some embodiments, the method further comprises the step of washing the temporary reaction chambers (40A, 40B), preferably after step e) and/or z).

The washing steps after the removal of the activation solution and/or the modification solution may remove other components, which are not bound or attached to the surface, present in the activation solution and/or the modification solution from the functionalized surface. Such a washing step may result in a cleaner functionalization or sample deposition and may remove contaminants which will lead to noise from the electron microscopy image or data. The washing is carried out within the temporary reaction chambers avoiding cross-contamination between the different functionalizations or sample deposits, which again increases the reliability of sample preparation and thus avoids noise on the electron microscopy image or data.

In some embodiments, removing the activation solution or the modification solution form the temporary reaction chambers may be performed by adding washing solution to the temporary reaction chambers, thereby pushing the activation solution or the modification solution out of the temporary reaction chambers, or by diluting the activation solution or the modification solution.

In some embodiments, the method further comprises the step of aspirating the temporary reaction chambers (40A, 40B), preferably after step e), and/or after the washing step.

Aspirating the temporary reaction chambers may speed up sample preparation or the preparation of the regioselective functionalized grid.

In some embodiments, different modification solutions and/or different activation solutions are used in different temporary reaction chambers.

In some embodiments, the modification solution (50, 50A, 50B) and/or the activation solution are provided in each temporary reaction chamber (40A, 40B) through a first fluid channel, preferably said first fluid channel is provided in the wall system (30A, 30B). Preferably, each temporary reaction chamber comprises a first fluid channel. Especially, when the temporary reaction chambers are closed, the first fluid channel allows for the delivery and the removal of solutions and wash solutions to the temporary reaction chamber.

In some embodiments, the modification solutions and/or the activation solution are removed from each temporary reaction chambers (40A, 40B) through a second fluid channel, preferably said first fluid channel is provided in the wall system (30A, 30B). Preferably, each temporary reaction chamber comprises a first fluid channel. When each temporary reaction chamber comprises a first and a second fluid channel, the first fluid channel can be used to deliver solutions and wash solutions to the temporary reaction chamber, whereas the second fluid channel can be used to remove the solutions and wash solutions from the temporary reaction chamber. The temporary reaction chamber comprises a first and a second fluid channel, continuous flow of solutions may be used during the method or during some method steps. Preferably, the first fluid channel is positioned on an opposite side of the temporary reaction chamber compared to the second fluid channel. In some embodiments, a wash solution delivered through the first fluid channel may be used to push out thereby removing an activation solution or a modification solution from the temporary reaction chamber through the second fluid channel.

In some embodiments, the area of each surface (21A, 21B) of the electron microscopy grid (10) in each of the temporary reaction chambers (40A, 40B) is at least 0.1 mm² to at most 5.0 mm², preferably at least 0.2 mm² to at most 4.0 mm², preferably at least 0.3 mm² to at most 3.0 mm², preferably at least 0.4 mm² to at most 2.5 mm², preferably at least 0.5 mm² to at most 2.2 mm², preferably at least 0.7 mm² to at most 2.0 mm². Such areas allow for a large number of different functionalizations to be present on a single EM grid.

In some embodiments, the area of each surface (21A, 21B) of the electron microscopy grid (10) in each of the temporary reaction chambers (40A, 40B) is at least 0.1 mm², preferably at least 0.2 mm², preferably at least 0.3 mm², preferably at least 0.4 mm², preferably at least 0.5 mm², preferably at least 0.7 mm².

In some embodiments, the area of each surface (21A, 21B) of the electron microscopy grid (10) in each of the temporary reaction chambers (40A, 40B) is at most 5.0 mm², preferably at most 4.0 mm², preferably at most 3.0 mm², preferably at most 2.5 mm², preferably at most 2.2 mm², preferably at most 2.0 mm².

In some embodiments, the thickness of the walls in the wall system is at least 10 µm to at most 500 µm, preferably at least 20 µm to at most 400 µm, preferably at least 30 µm to at most 350 µm, preferably at least 40 µm to at most 300 µm, preferably at least 50 µm to at most 250 µm, preferably at least 75 µm to at most 200 µm, preferably at least 100 µm to at most 150 µm. Such wall systems allow for the placement of different functionalizations close to each other and allow that a high percentage of the total surface of the EM grid is functionalized.

In some embodiments, the thickness of the walls in the wall system is at least 10 µm, preferably at least 20 µm, preferably at least 30 µm, preferably at least 40 µm, preferably at least 50 µm, preferably at least 75 µm, preferably at least 100 µm.

In some embodiments, the thickness of the walls in the wall system is at most 500 µm, preferably at most 400 µm, preferably at most 350 µm, preferably at most 300 µm, preferably at most 250 µm, preferably at most 200 µm, preferably at most 150 µm.

In some embodiments, the method further comprises the step of sealing the junction between the surface of the electron microscopy grid and the wall system. The sealing is configured to prevent leakages of the solutions from the temporary reaction chambers, which would otherwise lead to cross-contamination. In some embodiments, a gasket or washer is applied in or around the junction, preferably is the gasket or washer made from an elastic material. In some embodiments, a micro-gasket is employed to connect the wall system to the surface of the electron microscopy grid. Said micro-gasket is preferably configured to be tightly interposed between the wall system and the surface of the electron microscopy. Said micro-gasket preferably comprises elastic material, preferably elastic material featuring a certain rigidity to foster placement and handling. Such micro-gasket may allow to prevent leakage due to surface irregularities of the electron microscopy grid. In some embodiments, the micro-gasket may comprise silicone, ethylene propylene diene monomer (EPDM) rubber, Fluorocarbon-based fluoro-elastomer rubber (FKM, FFKM), and/or Polytetrafluoroethylene (PTFE). In some embodiments, said micro-gasket has a thickness of at least 100 µm to at most 700 µm, preferably at least 200 µm to at most 600 µm, preferably at least 300 µm to at most 500 µm. In some embodiments, said micro-gasket has a shore A value at least 10 to at most 100, preferably at least 12.5 to at most 95, preferably at least 20 to at most 90, preferably at least 25 to at most 80 preferably at least 30 to at most 70 preferably at least 40 to at most 60. In some embodiments, said micro-gasket is biocompatible, and/or chemically inert towards water solutions, buffers, or typical organic solutions. In some embodiments, said micro-gasket may be manufactured through laser cutting.

In some embodiments, a coating is applied on the inside of the temporary reaction chamber, preferably before the activation solution or modification solution is provided in the temporary reaction chamber, preferably the coating is a hydrophobic coating. In some embodiments, said coating is biocompatible, and/or chemically inert towards water solutions, buffers, or typical organic solutions. In some embodiments, the coating is chosen from the list comprising MagnaCoat^{®}, TempCoat^{®}, PlasmaCoat^{®}, Parylene, COAT-X^{®}, COMELEC^{®}, Kapton polyimide^{®}, Teflon^{®}, Silicone Polydimethylsiloxane. Such coatings may have a certain elasticity to balance-out irregularities between an electron microscopy grid and the wall system.

In some embodiments, the surface of an electron microscopy grid may be subject to process of surface roughness reduction through electropolishing processes. The latter may allow for any potential gap between the surface of an electron microscopy grid and a wall system to be removed, ensuring a seamless contact among surfaces, reducing the risk of leakage of the solutions from the temporary reaction chambers.

In some embodiments, pressure is applied pressing the wall system against the surface of the EM grid. Preferably, a clamping device is used to apply pressure on the wall system.

Disclosed is further, outside the scope of the claims, an electron microscopy grid comprising a layered structure, wherein the layered structure comprises the following layers, preferably in the following order:
- a substrate, preferably a metal substrate, preferably a metal framework; and,
- optionally a support film or a perforated support film on the substrate,
- a continuous film, comprising a contact surface, which faces the substrate or the support film, and wherein said continuous film comprises an exposed surface opposite to the contact surface;
wherein the substrate and/or the support film comprising a plurality of perforated areas, separated and surrounded by solid areas.

More particular, disclosed is an electron microscopy grid, suitable to be used in a method according to an embodiment disclosed herein, wherein the electron microscopy grid, comprises a layered structure, wherein the layered structure comprises the following layers, preferably in the following order:
- a substrate, preferably a metal substrate, preferably a metal framework; and,
- optionally a support film or a perforated support film on the substrate,
- a continuous film, comprising a contact surface, which faces the substrate or the support film, and wherein said continuous film comprises an exposed surface opposite to the contact surface;
characterised in that,
the substrate and/or the support film comprising a plurality of perforated areas, separated and surrounded by solid areas.

The solid areas of the substrate and/or the support film may be used to support a wall system which may be provided on the continuous film. The solid areas supporting the wall system may provide a leak free junction between the wall system and the continuous film. Preferably, the solid areas match the layout of the wall systems, intended to be provided on the grid to create temporary reaction chambers. Preferably, the perforated areas support the continuous film in the regions intended to be functionalized.

As used herein, the term "perforated" means having through-holes therein. The term "solid area" as used inhere refers to area with no perforation in it. In some embodiments, the trough-holes are rectangular, square or hexagonal.

In some embodiments, the substrate comprises mesh structures. Preferably the mesh structure has a square size from at least 10 x 10 µm to at most 300 x 300 µm, preferably at least 20 x 20 µm to at most 250 x 250 µm, preferably at least 40 x 40 µm to at most 200 x 200 µm, preferably at least 60 x 60 µm to at most 150 x 150 µm, preferably at least 80 x 80 µm to at most 100 x 100 µm, preferably 90 x 90 µm.

In some embodiments, the substrate comprises bars, preferably with a bar size of at least 10 µm to at most 100 µm, preferably at least 15 µm to at most 80 µm, preferably at least 20 µm to at most 60 µm, preferably at least 25 µm to at most 50 µm, preferably at least 30 µm to at most 40 µm, like 37µm.

In some embodiments, the substrate may comprise a metal. In embodiments, the metal may be selected from the list of Cu, Ni, Ti, Si, Au, CuRh, Mo, Al and W.

In some embodiments, the substrate comprises a rim, preferably a solid rim.

In some embodiments, the continuous film is a graphene-oxide continuous film, a graphite continuous film, a carbon continuous film, a silicone oxide continuous film or a silicon nitride continuous film.

In certain embodiments, the continuous film having a thickness of 60 Å or less, preferably 40 Å or less preferably 20 Å or less, preferably 10 Å or less, preferably 3 Å or less.

In embodiments, the continuous film may be selected from graphene, graphene oxide and graphite. In other embodiments, the continuous film may be formed of another 2D material (e.g. a transition metal dichalcogenide or hexagonal boron nitride), another carbon-based material (e.g. amorphous carbon, diamond or diamond-like carbon), a semiconductor material (e.g. a thin layer of silicon or silicon dioxide), an organic molecule (e.g. a self-assembled monolayer, SAM) or a bio-molecule. In some embodiments, the continuous film may be molecularly or atomically thin, preferably atomically thin. In some embodiments, the continuous film may be a molecular monolayer (e.g. a SAM) or an atomic monolayer (e.g. single-layer graphene or other 2D material); preferably an atomic monolayer. Thinner continuous film advantageously interferes less with the EM imaging; the EM signal (i.e. the effect on amplitude and phase contrast) produced by vanishingly thin (e.g. atomically thin) continuous films may, for example, be neglectable.

In some embodiments, the support film is a metallic (e.g. Au) support film, a carbon support film, a silicone oxide support film or a silicon nitride support film.

In some embodiments, the support film (e.g foil) may comprise a material selected from amorphous carbon, Au, TiSi, SiN, SiO2 and SiC. In some embodiments, the support film may have a thickness of from 1 to 50 nm, e.g. from 5 to 30 nm. In some embodiments, the support film (e.g. a foil) may be a lacey foil (e.g. a lacey carbon foil), a holey foil (e.g. a holey carbon foil) or a Quantifoil. These perforated foils may be commercially available. In embodiments, the perforated substrate and/or the support film (e.g. foil) may comprise random perforations (e.g. as in lacey or holey foil) or regularly patterned perforations (e.g. as in Quantifoil).

In some embodiments, the optional support film and/or the continuous film may be formed on the substrate, or the optional support film, the continuous film and the substrate may be assembled. In some embodiments, transferring the support film and or continuous film may comprise a wet transfer, dry transfer or sandwich-based transfer. Such a wet- or dry- transfer is described for pristine (i.e. unfunctionalized) graphene by Suk et al. (SUK, Ji Won, et al. Transfer of CVD-grown monolayer graphene onto arbitrary substrates. ACS nano, 2011, 5.9: 6916-6924.), which is incorporated herein by reference.

The sandwich-based transfer of graphene onto non-copper supports with foils has been described in particular for electron microscopy grids by Passmore and Russo (PASSMORE, Lori A.; RUSSO, Christopher J. Specimen preparation for high-resolution cryo-EM. In: Methods in enzymology. Academic Press, 2016. p. 51-86.). Wet transfer of graphene has been described by Han et al. (HAN, Yimo at al, High-yield monolayer graphene grids for near-atomic resolution cryoelectron microscopy. In: PNAS January 14, 2020 117 (2) 1009-1014.)

In some embodiments, the continuous film is a graphene-oxide continuous film, a graphene continuous film, a carbon continuous film, a silicone oxide continuous film or a silicon nitride continuous film.

In some embodiments, the EM grid may be for (i.e. suitable for) protein structure determination. In some embodiments, the protein structure determination may have a resolution of 10 Å or less; i.e. it may be a high-resolution protein structure determination. Protein structure determination typically hinges on a good analyte EM signal, with minimal interference from the EM grid. In that respect, support films having a thickness of 20 Å or less typically yield a suitable signal-to-noise ratio, which is further improved for thicknesses of 10 Å or less, etc.; such thicknesses are therefore increasingly preferred. For comparison, a single graphene layer has a thickness of about 3 Å (e.g. 3.35 Å) In some embodiments, the support film may be an ordered (e.g. crystalline) support film. Ordered support films advantageously yield an EM signal (e.g. a regular EM signal) which can be subtracted from the overall EM signal, thereby reducing or removing the influence of the ordered support film on the EM imaging. In preferred embodiments, the support film may be a conductive support film. Conductive support films advantageously provide an avenue for electrical charge carriers to dissipate in, thereby counteracting local charging effect (e.g. on the analyte) that can occur and that may influence the EM signal.

In some embodiments, the electron microscopy grid is suitable to be used in a method for regioselective functionalizing a surface of an electron microscopy grid according to an embodiment described herein, or to be used in an apparatus for regioselective functionalizing a surface of an electron microscopy grid according to an embodiment described herein.

The invention further provides an apparatus for regioselective functionalizing a surface of an electron microscopy grid, comprising:
- a plurality of partially formed reaction chambers, each partially formed reaction chamber comprising at least a wall system;
- for each partially formed reaction chamber, a fluid inlet and/or fluid outlet in fluidly connection to said partially formed reaction chamber;
- an electron microscopy grid holder, to hold the electron microscopy grid and preferably configured to expose the surface to be modified to the partially formed reaction chambers;
- optionally, a press system or clamp system to press the electron microscopy grid and/or the object holder with the electron microscopy grid with the surface against the wall systems.

Preferably, the object holder is configured to hold the electron microscopy grid and configured to expose the surface to be modified to the partially formed reaction chambers thereby forming functioning temporary reaction chambers.

In some embodiments, each partially formed reaction chamber is connected to a first fluid channel. In some embodiments, each partially formed reaction chamber is connected to a second fluid channel.

In some embodiments, each partially formed reaction chamber is connected to a fluid handling system, suitable for providing a solution to the reaction chamber. Preferably, the fluid handling system is also suitable for removing a solution from the reaction chamber. Preferably, the fluid handling system is a microfluidic system, preferably an active or passive microfluidic system.

In some embodiments, the electron microscopy grid holder comprises a positioning element, such as a recess for a positioning pin. This way, the electron microscopy grid can only be placed in a single orientation inside the electron microscopy grid holder. This results in a good alignment between the grid and the partially formed reaction chambers. In some embodiments, the electron microscopy grid comprises a spare-out, preferably the spare out is form-congruent to placing element. The position of the grid can hereby be oriented continuous film side up or continuous film side down.

In some embodiments, the plurality of partially formed reaction chambers and/or the fluid channels are tooled, carved, ablated or etched in a first sheet. In some embodiments, the electron microscopy grid holder is tooled, carved, or etched is a second sheet. Preferably, the first sheet and the second sheet may be placed on top of each other, clamping the electron microscopy grid in between, thereby forming at least part of the apparatus.

In some embodiment, the electron microscopy grid holder is placed on a lever, said lever being suitable to press the electron microscopy grid or the electron microscopy grid holder against the plurality of partially formed reaction chambers.

Disclosed is further, outside the scope of the claims, a kit comprising at least one electron microscopy grid according to an embodiment described herein, and an apparatus for regioselective functionalizing a surface of an electron microscopy grid according to an embodiment described herein. In some embodiments of the kit, the substrate of the electron microscopy grid has solid zones, which align with the partially formed reaction chambers of the apparatus. In some embodiments of the kit, the substrate of the electron microscopy grid has solid zones, which align with the partially wall systems of the apparatus.

In some embodiments of the kit, the positioning element of the apparatus is congruent with the spare-out of the electron microscopy grid, so that the solid zones of the substrate of the electron microscopy grid align with the with the partially formed reaction chambers of the apparatus. In some embodiments of the kit, the positioning element of the apparatus has a shape which is congruent with the spare-out of the electron microscopy grid, so that the solid zones of the substrate of the electron microscopy grid align with the with the wall systems of the apparatus.

The invention further provides a method for structurally characterizing different analytes on a single electron microscopy grid, comprising:
- regioselective functionalizing the surface of an electron microscopy grid with different analytes, according to the method described herein, thereby obtaining different functionalized regions on the electron microscopy grid, preferably whereby each region comprises the same analyte immobilized with a different linker or whereby each region comprises a similar linker with a different analyte or analyte complex;
- freezing the electron microscopy grid obtained in a);
- loading the electron microscopy grid obtained in b) into an electron microscope;
- acquiring electron microscopy images for every differently modified region of the electron microscopy grid;
- reconstructing the three-dimensional volume of the analytes based on the acquired electron microscopy images.

In some embodiments, reconstructing the three-dimensional volume of the analytes based on the acquired electron microscopy images involves analyte picking, analyte classification and/or analyte refinement algorithms thereby obtaining a three-dimensional reconstruction of the analytes based on the two-dimensional electron microscopy images.

In some embodiments, electron microscopy images may be acquired using transmission electron microscopy (TEM). Hence, in some embodiments, the EM grid may be a TEM grid.

In some embodiments, electron microscopy images may be acquired by cryo-electron microscopy and/or negative stain electron microscopy, preferably by cryo-electron microscopy.

### Examples

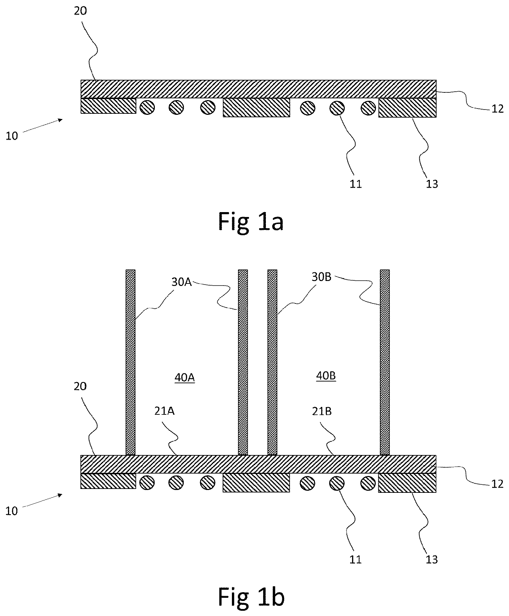

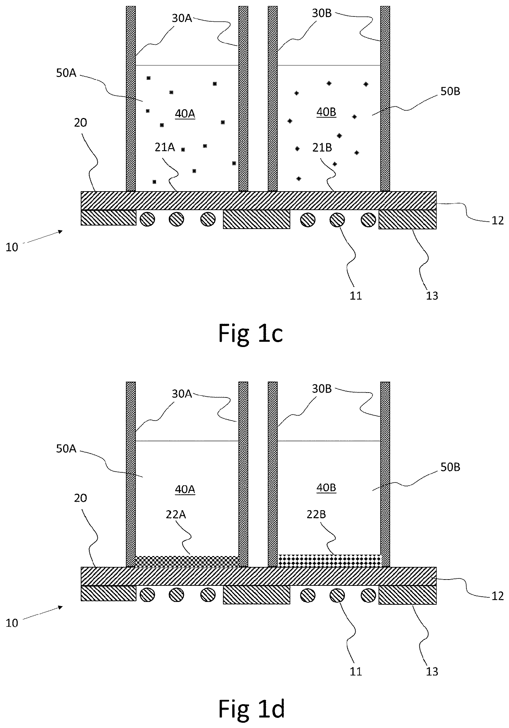

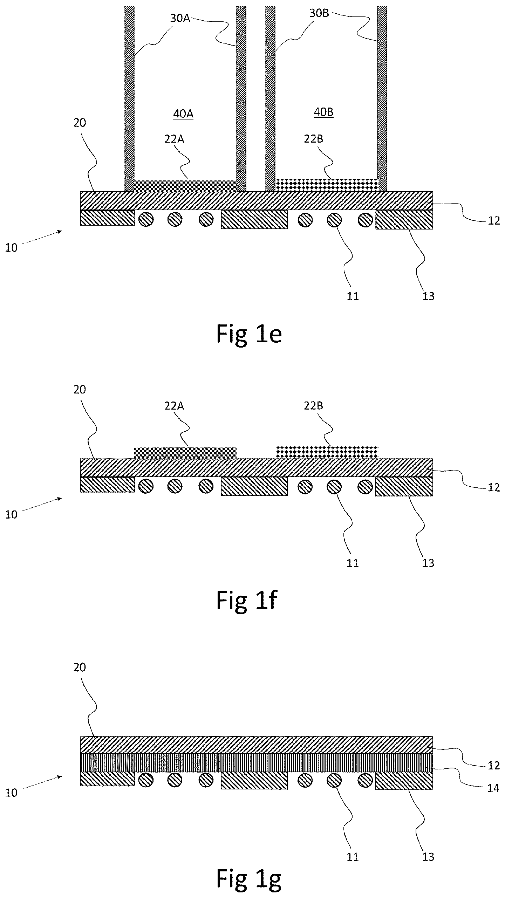

**Figure 1** depicts a method for regioselective functionalizing a surface (20) of an electron microscopy grid (10) according to an embodiment of the invention. In this example the EM grid (10) as shown in Fig. 1a is formed from a continuous film (12) on a metal support, which comprises solid non-perforated parts (13) and mesh parts, formed by bars (11). In Fig. 1b, wall systems (30A, 30B) are provided on the surface (20) to be functionalized, forming temporary reaction chambers (40A, 40B). The floors of the temporary reaction chambers (40A, 40B) are formed by the parts (21A, 21B) of the surface (20) to be functionalized. The temporary reaction chambers (40A, 40B) are open at the top, the opening can be used to provide solutions to the temporary reaction chambers (40A, 40B), as shown in Fig. 1c, wherein the temporary reaction chambers (40A, 40B) are each filled with a different modification solution (50A, 50B). In a following step, the surface (21A, 21B) inside the temporary reaction chambers is modified with compounds from the modification solution (50A, 50B), thereby forming regioselective functionalized surfaces (22A, 22B), as depicted in Fig. 1d. As shown in Fig. 1e, the remaining modification solution is removed. This is followed by the removal of the walls systems (30A, 30B) of surface (20) of the EM grid (10), as shown in Fig. 1f, only leaving the regioselective functionalizations (22A, 22B) on the surface (20).

One skilled in the art, would understand that the same method for regioselective functionalizing a surface (20) of an electron microscopy grid (10) as described above can be done starting from an electron microscopy grid (10) as depicted in Fig. 1g, which comprises the same features as the EM grid depicted in Fig.1a, however, a perforated substrate (14) is present between the metal support and the continuous film (12). Typically, the size of the perforations in the support film ranges from about 0.2 to about 0.6 µm, whereas the size of the holes in the metal support ranges from about 28 µm to about 425 µm.

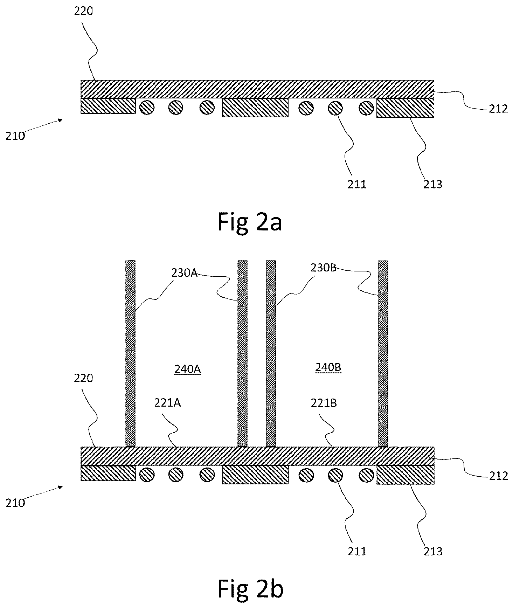

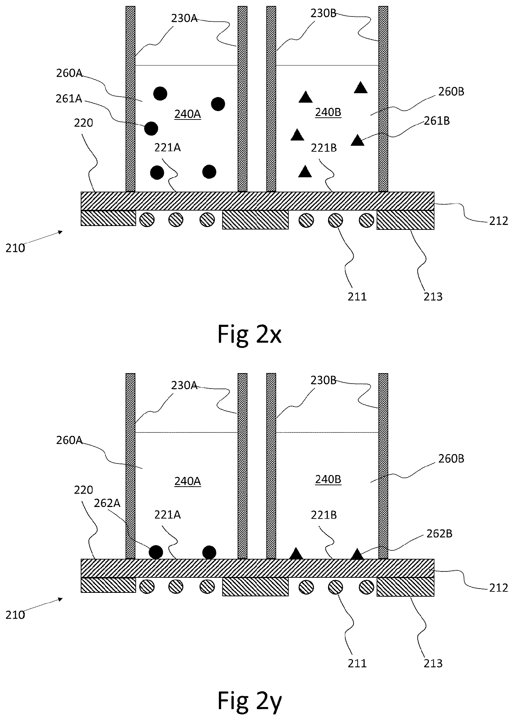

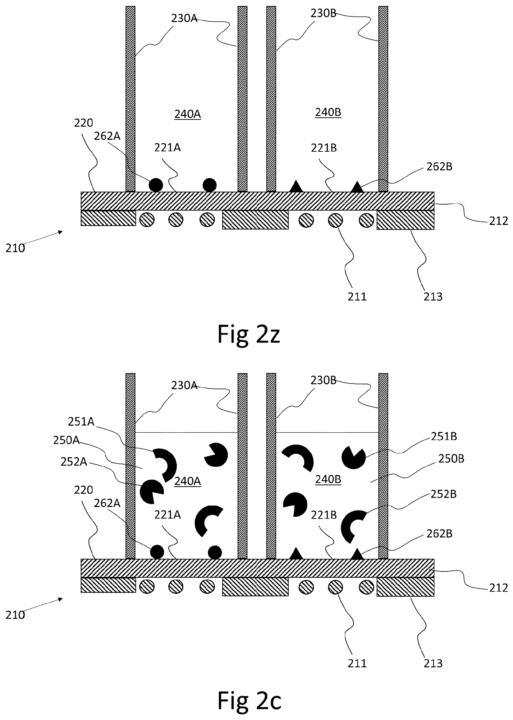

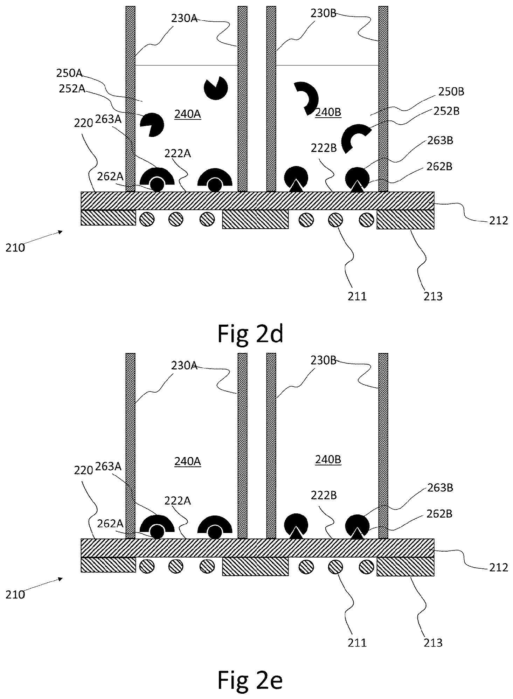

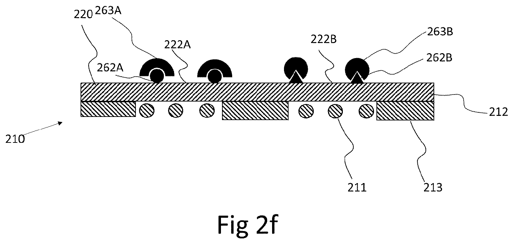

**Figure 2** depicts a method for regioselective functionalizing a surface (220) of an electron microscopy grid (210) according to an embodiment of the invention, wherein the electron microscopy grid (210) functions as an affinity grid. In this example the EM grid (210) as shown in Fig. 2a is formed from a continuous film (212) on a metal support, which comprise solid non-perforated parts (213) and mesh parts, formed by bars (211). In Fig. 2b, wall systems (230A, 230B) are provided on the surface (220) to be functionalized, forming temporary reaction chambers (240A, 240B). The floors of the temporary reaction chambers (240A, 240B) are formed by the parts (221A, 221B) of the surface (220) to be functionalized. The temporary reaction chambers (240A, 240B) are open at the top, the opening can be used to provide solutions to the temporary reaction chambers (240A, 240B), as shown in Fig. 2x, wherein the temporary reaction chambers (240A, 240B) are each filled with a different activation solution (260A, 260B), each comprising a different reactive affinity group (261A, 261B). These reactive affinity group (261A, 261B) are reacted with the parts (221A, 221B) of the surface (220) inside the temporary reaction chambers (240A, 240B), as shown in Fig. 2y, thereby binding the affinity groups (262A, 262B) to the surface (221A, 221B) in the temporary reaction chambers (240A, 240B). After the removal of the activation solutions (260A, 260B) from the temporary reaction chambers (240A, 240B) shown in Fig. 2z; modification solution (250A, 250B) is added to the temporary reaction chambers (240A, 240B) as shown in Fig. 2c. The modification solution may comprise a mixture of compounds (251A, 251B, 252A, 252B), of which some components comprise an affinity tag which specifically binds to the surface bound affinity groups (262A, 262B). Fig. 2d shows the specific binding of one component (263A, 263B) of the modification solution (250A, 250B) to the part of the surface now being functionalized (222A, 222B), and this in the presence of other components (252A, 252B) in the modification solution (250A, 250B). As shown in Fig. 2e, the remaining modification solution ((250A, 250B) still comprising the other components (252A, 252B) is removed. Which is followed by the removal of the walls systems (230A, 230B) of surface (220) of the EM grid (210), as shown in Fig. 2f, only leaving the regioselective functionalizations (222A, 222B) on the surface (220).

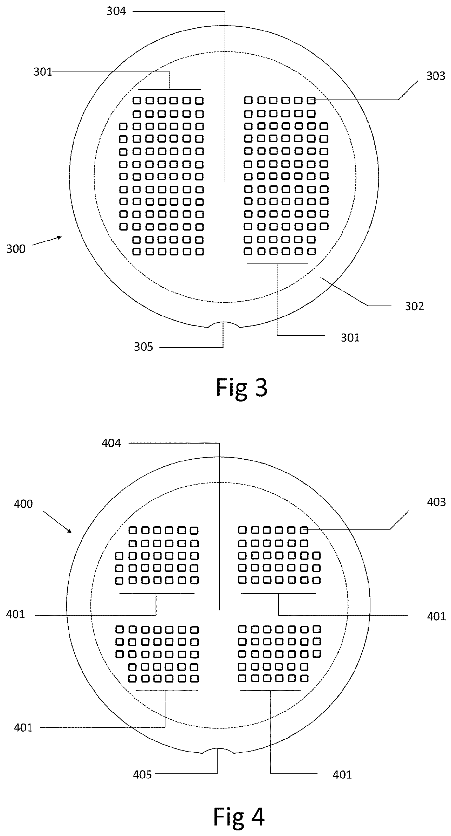

**Figure 3** shows a top view of a substrate (300) of an electron microscopy grid. The substrate comprises two perforated areas (301), comprising perforations (303), said two perforated areas (301) being separated and surrounded by solid areas (302, 304). The substrate (300) comprises a solid rim (302), wherein a spare out (305) is present.

**Figure 4** shows a top view of a substrate (400) of an electron microscopy grid. The substrate comprises four perforated areas (401), comprising perforations (403), said four perforated areas (401) being separated and surrounded by solid areas (402, 404). The substrate (400) comprises a solid rim (402), wherein a spare out (405) is present.

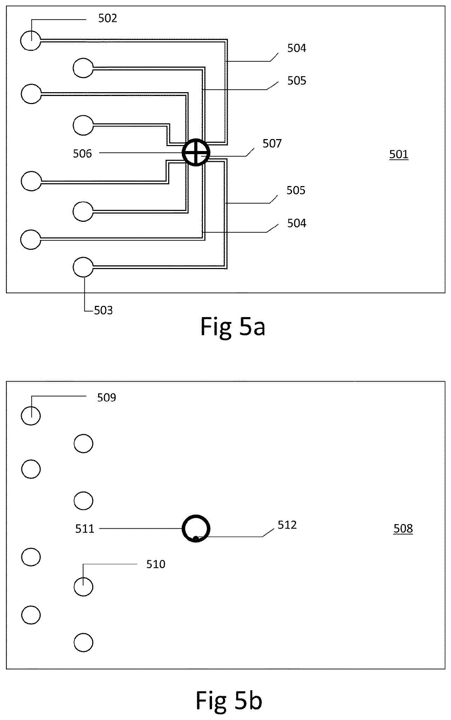

**Figure 5a** and **Figure 5b** shows an apparatus for regioselective functionalizing a surface of an electron microscopy grid according to an embodiment of the invention. The apparatus is formed out of base sheets (501) and a cover sheet (508). In the base sheet (501), four partially formed reaction chambers (507) are carved, separated by wall systems (506). To each partially formed reaction chambers (507), a fluid inlet (502) is connected via a first fluid channel (504). To each partially formed reaction chambers (507), a fluid outlet (503) is connected via a second fluid channel (505). The cover sheet (508) comprises the electron microscopy grid holder (511), which itself comprises a positioning element (512), form congruent to the spare out of the EM grid according to an embodiment of the invention. The cover sheet (508) further comprises inlet apertures (509) and outlet apertures (510) through which the fluid inlets (502) and fluid outlets (503) can be reached when the cover sheet is placed on top of the base sheet.

## Claims

1. A method for regioselective functionalizing a surface of an electron microscopy grid (EM grid) (10), preferably a surface of a cryo-electron microscopy (cryo-EM) grid, preferably a surface of an affinity EM grid or an affinity cryo-EM grid, comprising the steps of:
a) providing a surface (20) of an electron microscopy grid (101) to be functionalized, preferably regioselective functionalized;
b) providing a plurality of wall systems (30A, 30B) on at least one part of the surface of an electron microscopy grid, thereby forming a plurality of temporary reaction chambers (40A, 40B) wherein the at least one part of the surface (21A, 21B) of an electron microscopy grid (10) forms a floor or a ceiling of the temporary reaction chambers;
c) providing a modification solution (50) or a different modification solution (50A, 50B) in each temporary reaction chambers (40A, 40B);
d) modifying the parts of the surface (21A, 21B) of an electron microscopy grid (10) in the temporary reaction chambers (40A, 40B) with the modification solution(s) (50, 50A, 50B) or components comprised in the modification solution(s) (50, 50A, 50B);
e) removing the modification solution(s) (50, 50A, 50B) from the temporary reaction chambers (40A, 40B);
f) removing the plurality of wall systems (30A, 30B) from the surface (20) of a microscopy grid (10), thereby providing a regioselective functionalized surface (22A, 22B) of an electron microscopy grid (10).

2. The method according to claim 1, comprising the following steps, which are carried out after step b) and before step c):
x. providing an activation solution or a different activation solution in the temporary reaction chambers (40A, 40B), wherein the activation solution(s) comprises reactive affinity groups;
y. reacting the part of the surface of a microscopy grid (10) in the temporary reaction chambers (40A, 40B) with the activation solution(s) providing activated parts of the surface, preferably thereby binding the affinity groups to the part of the surface (21A, 21B) of the electron microscopy grid (10) in a plurality of reaction chambers (40A, 40B);
z. removing the activation solution(s) from the temporary reaction chambers (40A, 40B); and;
wherein the modification solution(s) (50, 50A, 50B) comprises an analyte, which analyte specifically binds to or reacts with the activated part of the surface, preferably wherein the analyte comprises a binding motif or affinity tag, which specifically binds to, or reacts with the affinity groups.

3. The method according to claim 1, wherein the method further comprises the step of washing the temporary reaction chambers (40A, 40B), preferably after step e) and/or z).

4. The method according to claim 1 or claim 2, wherein the method further comprises the step of aspirating the temporary reaction chambers (40A, 40B), preferably after step e), and/or after the washing step.

5. The method according to any one of the preceding claims, wherein the modification solution (50, 50A, 50B) and/or the activation solution are provided in each temporary reaction chamber (40A, 40B) through a first fluid channel, preferably said first fluid channel is provided in the wall system (30A, 30B).

6. The method according to any one of the preceding claims, wherein the modification solutions and/or the activation solution are removed from each temporary reaction chambers (40A, 40B) through a second fluid channel, preferably said first fluid channel is provided in the wall system (30A, 30B).

7. The method according to any one of the preceding claims, wherein the area of each surface (21A, 21B) of the electron microscopy grid (10) in each of the temporary reaction chambers (40A, 40B) is at least 0.1 mm² to at most 5.0 mm², preferably at least 0.2 mm² to at most 4.0 mm², preferably at least 0.3 mm² to at most 3.0 mm², preferably at least 0.4 mm² to at most 2.5 mm², preferably at least 0.5 mm² to at most 2.2 mm², preferably at least 0.7 mm² to at most 2.0 mm².

8. The method according to any one of the preceding claims, wherein the thickness of the walls in the wall system is at least 10 µm to at most 500 µm, preferably at least 20 µm to at most 400 µm, preferably at least 30 µm to at most 350 µm, preferably at least 40 µm to at most 300 µm, preferably at least 50 µm to at most 250 µm, preferably at least 75 µm to at most 200 µm, preferably at least 100 µm to at most 150 µm.

9. The method according to any one of the preceding claims, wherein the method further comprises the step of sealing the junction between the surface and the wall system.

10. An apparatus for regioselective functionalizing a surface of an electron microscopy grid, comprising:
- a plurality of partially formed reaction chambers, each partially formed reaction chamber comprising at least a wall system;
- for each partially formed reaction chamber, a fluid inlet and/or fluid outlet in fluidly connection to said partially formed reaction chamber;
- an electron microscopy grid holder, to hold the electron microscopy grid and configured to expose the surface to be modified to the partially formed reaction chambers; and,
- optionally, a press system or clamp system to press the electron microscopy grid and/or the object holder with the electron microscopy grid with the surface against the wall systems.

11. A method for structurally characterizing different analytes on a single electron microscopy grid, comprising:
- regioselective functionalizing the surface of an electron microscopy grid with different analytes, according to the method according to claims 1 to 9, thereby obtaining different functionalized regions on the electron microscopy grid;
- freezing the electron microscopy grid obtained in a);
- loading the electron microscopy grid obtained in b) into an electron microscope;
- acquiring electron microscopy images for every differently modified region of the electron microscopy grid; and,
- reconstructing the three-dimensional volume of the analytes based on the acquired electron microscopy images.

## Patentansprüche

1. Verfahren zur regioselektiven Funktionalisierung einer Oberfläche eines Elektronenmikroskopiegitters (EM-Gitters) (10), vorzugsweise einer Oberfläche eines Kryo-Elektronenmikroskopiegitters (Kryo-EM-Gitters), vorzugsweise einer Oberfläche eines Affinitäts-EM-Gitters oder eines Affinitäts-Kryo-EM-Gitters, umfassend die Schritte:
a) Bereitstellen einer Oberfläche (20) eines Elektronenmikroskopiegitters (101), die funktionalisiert werden soll, vorzugsweise regioselektiv funktionalisiert;
b) Bereitstellen einer Vielzahl von Wandsystemen (30A, 30B) auf mindestens einem Teil der Oberfläche eines Elektronenmikroskopiegitters, wodurch eine Vielzahl von temporären Reaktionskammern (40A, 40B) gebildet wird, wobei der mindestens eine Teil der Oberfläche (21A, 21B) eines Elektronenmikroskopiegitters (10) einen Boden oder eine Decke der temporären Reaktionskammern bildet;
c) Bereitstellen einer Modifikationslösung (50) oder einer anderen Modifikationslösung (50A, 50B) in jeder temporären Reaktionskammer (40A, 40B);
d) Modifizieren der Teile der Oberfläche (21A, 21B) eines Elektronenmikroskopiegitters (10) in den temporären Reaktionskammern (40A, 40B) mit der/den Modifikationslösung(en) (50, 50A, 50B) oder Komponenten, die die Modifikationslösung(en) (50, 50A, 50B) umfassen;
e) Entfernen der Modifikationslösung(en) (50, 50A, 50B) aus den temporären Reaktionskammern (40A, 40B);
f) Entfernen der Vielzahl von Wandsystemen (30A, 30B) von der Oberfläche (20) eines Mikroskopiegitters (10), wodurch eine regioselektiv funktionalisierte Oberfläche (22A, 22B) eines Elektronenmikroskopiegitters (10) bereitgestellt wird.

2. Verfahren nach Anspruch 1, umfassend die folgenden Schritte, die nach Schritt b) und vor Schritt c) durchgeführt werden:
x. Bereitstellen einer Aktivierungslösung oder einer anderen Aktivierungslösung in den temporären Reaktionskammern (40A, 40B), wobei die Aktivierungslösung(en) reaktive Affinitätsgruppen umfassen;
y. Reagieren des Teils der Oberfläche eines Mikroskopiegitters (10) in den temporären Reaktionskammern (40A, 40B), wobei die Aktivierungslösung(en) die aktivierte Teile der Oberfläche bereitstellt (bereitstellen), wodurch vorzugsweise die Affinitätsgruppen an den Teil der Oberfläche (21A, 21B) des Elektronenmikroskopiegitters (10) in einer Vielzahl von Reaktionskammern (40A, 40B) gebunden werden;
z. Entfernen der Aktivierungslösung(en) aus den temporären Reaktionskammern (40A, 40B); und;
wobei die Modifikationslösung(en) (50, 50A, 50B) einen Analyten umfasst (umfassen), wobei der Analyt spezifisch an den aktivierten Teil der Oberfläche bindet oder mit diesem reagiert, wobei der Analyt vorzugsweise ein Bindungsmotiv oder eine Affinitätsmarkierung umfasst, die spezifisch an die Affinitätsgruppen bindet oder mit diesen reagiert.

3. Verfahren nach Anspruch 1, wobei das Verfahren ferner den Schritt des Waschens der temporären Reaktionskammern (40A, 40B) umfasst, vorzugsweise nach Schritt e) und/oder z).

4. Verfahren nach Anspruch 1 oder Anspruch 2, wobei das Verfahren ferner den Schritt des Absaugens der temporären Reaktionskammern (40A, 40B) umfasst, vorzugsweise nach Schritt e) und/oder nach dem Waschschritt.

5. Verfahren nach einem der vorhergehenden Ansprüche, wobei die Modifikationslösung (50, 50A, 50B) und/oder die Aktivierungslösung in jeder temporären Reaktionskammer (40A, 40B) durch einen ersten Fluidkanal bereitgestellt werden, wobei der erste Fluidkanal vorzugsweise in dem Wandsystem (30A, 30B) bereitgestellt ist.

6. Verfahren nach einem der vorhergehenden Ansprüche, wobei die Modifikationslösungen und/oder die Aktivierungslösung aus jeder temporären Reaktionskammer (40A, 40B) durch einen zweiten Fluidkanal entfernt werden, wobei vorzugsweise der erste Fluidkanal in dem Wandsystem (30A, 30B) bereitgestellt wird.

7. Verfahren nach einem der vorhergehenden Ansprüche, wobei die Fläche jeder Oberfläche (21A, 21B) des Elektronenmikroskopiegitters (10) in jeder der temporären Reaktionskammern (40A, 40B) mindestens 0,1 mm² bis höchstens 5,0 mm², vorzugsweise mindestens 0,2 mm² bis höchstens 4,0 mm², vorzugsweise mindestens 0,3 mm² bis höchstens 3,0 mm², vorzugsweise mindestens 0,4 mm² bis höchstens 2,5 mm², vorzugsweise mindestens 0,5 mm² bis höchstens 2,2 mm², vorzugsweise mindestens 0,7 mm² bis höchstens 2,0 mm² ist.

8. Verfahren nach einem der vorhergehenden Ansprüche, wobei die Dicke der Wände in dem Wandsystem mindestens 10 µm bis höchstens 500 µm, vorzugsweise mindestens 20 µm bis höchstens 400 µm, vorzugsweise mindestens 30 µm bis höchstens 350 µm, vorzugsweise mindestens 40 µm bis höchstens 300 µm, vorzugsweise mindestens 50 µm bis höchstens 250 µm, vorzugsweise mindestens 75 µm bis höchstens 200 µm, vorzugsweise mindestens 100 µm bis höchstens 150 µm ist.

9. Verfahren nach einem der vorhergehenden Ansprüche, wobei das Verfahren ferner den Schritt des Abdichtens der Verbindung zwischen der Oberfläche und dem Wandsystem umfasst.

10. Vorrichtung zur regioselektiven Funktionalisierung einer Oberfläche eines Elektronenmikroskopiegitters, umfassend:
eine Vielzahl von teilweise ausgebildeten Reaktionskammern, wobei jede teilweise ausgebildete Reaktionskammer mindestens ein Wandsystem umfasst;
für jede teilweise ausgebildete Reaktionskammer einen Fluid-Einlass und/oder Fluid-Auslass, der in Fluidverbindung mit der teilweise ausgebildeten Reaktionskammer steht;
einen Elektronenmikroskopiegitterhalter, der das Elektronenmikroskopiegitter hält und konfiguriert ist, um die zu modifizierende Oberfläche den teilweise ausgebildeten Reaktionskammern auszusetzen; und,
optional ein Presssystem oder Klemmsystem, um das Elektronenmikroskopiegitter und/oder den Objekthalter mit dem Elektronenmikroskopiegitter mit der Oberfläche gegen die Wandsysteme zu drücken.

11. Verfahren zur strukturellen Charakterisierung unterschiedlicher Analyten auf einem einzigen Elektronenmikroskopiegitter, umfassend:
Regioselektive Funktionalisierung der Oberfläche eines Elektronenmikroskopiegitters mit verschiedenen Analyten gemäß dem Verfahren nach Anspruch 1 bis 9, wodurch verschiedene funktionalisierte Bereiche auf dem Elektronenmikroskopiegitter erlangt werden;
Einfrieren des in a) erlangten Elektronenmikroskopiegitters;
Laden des in b) erlangten Elektronenmikroskopiegitters in ein Elektronenmikroskop;
Aufnehmen von Elektronenmikroskopiebildern für jeden unterschiedlich modifizierten Bereich des Elektronenmikroskopiegitters; und,
Rekonstruieren des dreidimensionalen Volumens der Analyten auf der Grundlage der aufgenommenen Elektronenmikroskopiebilder.

## Revendications

1. Procédé de fonctionnalisation régiosélective d'une surface d'une grille de microscopie électronique (grille EM) (10), de préférence d'une surface d'une grille de cryomicroscopie électronique (cryo-EM), de préférence d'une surface d'une grille EM d'affinité ou d'une grille cryo-EM d'affinité, comprenant les étapes suivantes :
a) la fourniture d'une surface (20) d'une grille de microscopie électronique (101) à fonctionnaliser, de préférence fonctionnalisée de manière régiosélective ;
b) la fourniture d'une pluralité de systèmes de parois (30A, 30B) sur au moins une partie de la surface d'une grille de microscopie électronique, formant ainsi une pluralité de chambres de réaction temporaires (40A, 40B) dans lequel au moins une partie de la surface (21A, 21B) d'une grille de microscopie électronique (10) forme un plancher ou un plafond des chambres de réaction temporaires ;
c) la fourniture d'une solution de modification (50) ou d'une solution de modification différente (50A, 50B) dans chaque chambre de réaction temporaire (40A, 40B) ;
d) la modification des parties de la surface (21A, 21B) d'une grille de microscopie électronique (10) dans les chambres de réaction temporaires (40A, 40B) avec la ou les solutions de modification (50, 50A, 50B) ou des composants compris dans la ou les solutions de modification (50, 50A, 50B) ;
e) le retrait de la ou des solutions de modification (50, 50A, 50B) des chambres de réaction temporaires (40A, 40B) ;
f) le retrait de la pluralité de systèmes de parois (30A, 30B) de la surface (20) d'une grille de microscopie (10), fournissant ainsi une surface fonctionnalisée régiosélective (22A, 22B) d'une grille de microscopie électronique (10).

2. Procédé selon la revendication 1, comprenant les étapes suivantes, qui sont réalisées après l'étape b) et avant l'étape c) :
x. la fourniture d'une solution d'activation ou d'une solution d'activation différente dans les chambres de réaction temporaires (40A, 40B), dans lequel la ou les solutions d'activation comprennent des groupes d'affinité réactifs ;
y. la réaction de la partie de la surface d'une grille de microscopie (10) dans les chambres de réaction temporaires (40A, 40B) avec la ou les solutions d'activation fournissant des parties activées de la surface, liant ainsi de préférence les groupes d'affinité à la partie de la surface (21A, 21B) de la grille de microscopie électronique (10) dans une pluralité de chambres de réaction (40A, 40B) ;
z. le retrait de la ou des solutions d'activation des chambres de réaction temporaires (40A, 40B) ; et ;
dans lequel la ou les solutions de modification (50, 50A, 50B) comprennent un analyte, lequel analyte se lie spécifiquement à ou réagit avec la partie activée de la surface, de préférence dans lequel l'analyte comprend un motif de liaison ou une étiquette d'affinité, qui se lie spécifiquement aux groupes d'affinité ou réagit avec ceux-ci.

3. Procédé selon la revendication 1, dans lequel le procédé comprend également l'étape de lavage des chambres de réaction temporaires (40A, 40B), de préférence après l'étape e) et/ou z).

4. Procédé selon la revendication 1 ou la revendication 2, dans lequel le procédé comprend également l'étape d'aspiration des chambres de réaction temporaires (40A, 40B), de préférence après l'étape e) et/ou après l'étape de lavage.

5. Procédé selon l'une quelconque des revendications précédentes, dans lequel la solution de modification (50, 50A, 50B) et/ou la solution d'activation sont fournies dans chaque chambre de réaction temporaire (40A, 40B) à travers un premier canal de fluide, de préférence ledit premier canal de fluide est fourni dans le système de paroi (30A, 30B).

6. Procédé selon l'une quelconque des revendications précédentes, dans lequel les solutions de modification et/ou la solution d'activation sont retirées de chacune des chambres de réaction temporaires (40A, 40B) à travers un second canal fluidique, de préférence ledit premier canal fluidique est de préférence prévu dans le système de paroi (30A, 30B).

7. Procédé selon l'une quelconque des revendications précédentes, dans lequel la zone de chaque surface (21A, 21B) de la grille de microscopie électronique (10) dans chacune des chambres de réaction temporaires (40A, 40B) est d'au moins 0,1 mm² à au plus 5,0 mm², de préférence d'au moins 0,2 mm² à au plus 4,0 mm², de préférence d'au moins 0,3 mm² à au plus 3,0 mm², de préférence d'au moins 0,4 mm² à au plus 2,5 mm², de préférence d'au moins 0,5 mm² à au plus 2,2 mm², de préférence d'au moins 0,7 mm² à au plus 2,0 mm².

8. Procédé selon l'une quelconque des revendications précédentes, dans lequel l'épaisseur des parois du système de paroi est d'au moins 10 µm à au plus 500 µm, de préférence d'au moins 20 µm à au plus 400 µm, de préférence d'au moins 30 µm à au plus 350 µm, de préférence d'au moins 40 µm à au plus 300 µm, de préférence d'au moins 50 µm à au plus 250 µm, de préférence d'au moins 75 µm à au plus 200 µm, de préférence d'au moins 100 µm à au plus 150 µm.

9. Procédé selon l'une quelconque des revendications précédentes, dans lequel le procédé comprend également l'étape de scellement de la jonction entre la surface et le système de paroi.

10. Appareil de fonctionnalisation régiosélective d'une surface d'une grille de microscopie électronique, comprenant :
- une pluralité de chambres de réaction partiellement formées, chaque chambre de réaction partiellement formée comprenant au moins un système de paroi ;
- pour chaque chambre de réaction partiellement formée, une entrée de fluide et/ou une sortie de fluide en connexion fluidique avec ladite chambre de réaction partiellement formée ;
- un support de grille de microscopie électronique, pour maintenir la grille de microscopie électronique et configuré pour exposer la surface à modifier aux chambres de réaction partiellement formées ; et,
- éventuellement, un système de presse ou un système de serrage pour presser la grille de microscopie électronique et/ou le support d'objet avec la grille de microscopie électronique avec la surface contre les systèmes de parois.

11. Procédé de caractérisation structurelle de différents analytes sur une seule grille de microscopie électronique, comprenant :
- la fonctionnalisation régiosélective de la surface d'une grille de microscopie électronique avec différents analytes, selon le procédé selon les revendications 1 à 9, obtenant ainsi différentes régions fonctionnalisées sur la grille de microscopie électronique ;
- la congélation de la grille de microscopie électronique obtenue en a) ;
- le chargement de la grille de microscopie électronique obtenue en b) dans un microscope électronique ;
- l'acquisition d'images de microscopie électronique pour chaque région modifiée différemment de la grille de microscopie électronique ; et,
- la reconstruction du volume tridimensionnel des analytes sur la base des images de microscopie électronique acquises.
